# EUROPÄISCHE PATENTSCHRIFT

(11) **EP 1 834 355 B1**
(45) Veröffentlichungstag und Bekanntmachung des Hinweises auf die Patenterteilung: **27.04.2011**
(21) Anmeldenummer: 05822975.8
(22) Anmeldetag: 01.12.2005
(51) Int. Cl.: H01L 23/473, H01L 23/467, H01L 23/427

(54) **KÜHLVORRICHTUNG ZUR KÜHLUNG EINES HALBLEITERBAUELEMENTES, INSBESONDERE EINES OPTOELEKTRONISCHEN HALBLEITERBAUELEMENTES**
COOLING DEVICE FOR COOLING A SEMICONDUCTOR COMPONENT, IN PARTICULAR, AN OPTOELECTRONIC SEMICONDUCTOR COMPONENT
DISPOSITIF DE REFROIDISSEMENT SERVANT A REFROIDIR UN COMPOSANT A SEMI-CONDUCTEURS, NOTAMMENT UN COMPOSANT A SEMI-CONDUCTEURS OPTOELECTRONIQUE

(30) Priorität: 30.12.2004 DE 102004063558
(43) Veröffentlichungstag der Anmeldung: 19.09.2007
(73) Patentinhaber: OSRAM Opto Semiconductors GmbH, 93055 Regensburg (DE)
(72) Erfinder: BOGNER, Georg, 93138 Lappersdorf (DE); BRUNNER, Herbert, 93161 Sinzing (DE); GRÖTSCH, Stefan, 93077 Lengfeld/Bad Abbach (DE); LEFRANC, Guy, 80689 München (DE)
(74) Vertreter: Epping - Hermann - Fischer
(86) Internationale Anmeldenummer: PCT/DE2005/002168
(87) Internationale Veröffentlichungsnummer: WO 2006/069554

(56) Entgegenhaltungen:
- DE-A1- 4 108 981
- US-A1- 2002 056 908
- US-A1- 2004 080 913
- US-A1- 2004 104 012
- US-B1- 6 252 726

## Beschreibung

Die Erfindung betrifft eine Vorrichtung zur Kühlung eines optischen Halbleiterbauelementes, unter Verwendung von flüssigen und gasförmigen Medien zum Wärmetransport.

Im Rahmen der fortschreitenden Leistungssteigerung generell aller Arten von Halbleiterbauelementen ist die damit einhergehende Erhöhung der Abwärme eines der Hauptprobleme. Eine Überhitzung von Halbleiterbauelementen muß verhindert werden, da sie primär die Funktion beeinträchtigt und bei gravierender Überhitzung das Bauelement auch zerstören kann.

Es ist bereits die Anwendung verschiedener Kühlungstechniken für elektrische Halbleiterbauelemente bekannt. Aus Druckschrift US 6,252,726 B1 ist die Verwendung von sogenannten Heatpipes zum dissipativen Wärmetransport bei optischen Bauelementen bekannt.

In der Druckschrift US 2003/0151896 A1 ist die Verwendung eines Thermosiphons zur Abgabe der überschüssigen wärmeenergie eines speziell hergerichteten Halbleiterbauelements an die Umgebungsluft genannt. Dabei wird eine Kühlvorrichtung mit verschiedenen Teilen wie Wärmeleitern und Kondensationsbereichen zusätzlich eingebaut.

In der Druckschrift US 2002/0056908 A1 ist eine wärmesenke zur Wärmedissipation beschrieben, die eine obere Wand mit hohlen Lamellen, eine Bodenwand sowie Seitenwände aufweist, die eine Kavität bilden.

Aus der Druckschrift US 6,252,726 B1 ist ein Gehäuse für optische Komponenten mit zwei Abdeckungen bekannt, bei dem die erste Abdeckung eine Heatpipe aufweist.

In der Druckschrift US 2004/0080913 A1 ist ein Halbleiterchip beschrieben, in dem eine Mehrzahl von Mikrokanälen ausgebildet ist, die zur Bildung eines Thermosiphons mit einem Kondensor gekoppelt sind.

Ein Mikrokanalkühler mit einer porösen Membran ist aus der Druckschrift US 2004/0104012 A1 bekannt.

Die Druckschrift DE 41 08 981 A1 betrifft eine Anordnung zur Wärmeabfuhr mittels eines Thermosyphonkreislaufs.

Die Anwendung von optoelektronischen Halbleiterbauelementen wie Leuchtdioden (LEDs), Laser oder LED- bzw. Laser-Feldanordnungen mit größerer Leistung gewinnt im alltäglichen Gebrauch immer mehr an Bedeutung. Sie werden als Ersatz für herkömmliche Leuchtkörper bei der Raumbeleuchtung, im Automobilbau, in der Unterhaltungselektronik oder als effiziente Quellen von Laserlicht verwendet. Bisher werden optoelektronische Halbleiterbauelemente auf Metallgitter, Flex on Aluminium oder Metallkernplatten montiert, um die durch Verlustleistung entstehende Wärme besser ableiten zu können. Aus Kostengründen werden in der Regel keine aktiven Kühlsysteme verwendet.

Mit den Leistungen steigen die Anforderungen an den Lichtfluss und die Leuchtdichte der Bauelemente in einem Maße, dass die herkömmliche Kühlung durch Wärmesenken nicht mehr ausreichend ist.

Eine Realisierung von herkömmlichen separaten Kühleinrichtungen mit Wärmeleitungen (Heatpipe, Thermosiphon) und Kondensatoren beeinträchtigt durch deren Platzbedarf allerdings die Einsatzmöglichkeiten von optoelektronischen Halbleiterbauelementen. Die zusätzlichen Teile der Kühlungseinrichtung verbrauchen Platz, bewirken ein zusätzliches Gewicht, beschränken die Freiheit der Gestaltung und sind mit hohen Kosten verbunden. Diese Tatsachen stellen limitierende Faktoren für eine breitere kommerzielle Anwendung der optoelektronischen Halbleiterbauelemente dar.

Eine Aufgabe der Erfindung ist es, eine Vorrichtung mit einer vereinfacht variabel einsetzbaren oder vielfältig integrierbaren Kühlvorrichtung anzugeben. Es sollen Bestandteile eines Kühlsystems mit einem einem optoelektronischen Halbleiterbauelement, funktionell integriert werden. Hierbei können vorzugsweise Bestandteile eines Kühlsystems, die zusätzlich eine andere Funktion erfüllen können, mit einem Halbleiterbauelement integriert werden.

Diese Aufgabe wird durch eine Vorrichtung mit den Merkmalen des Patentanspruchs 1 gelöst. Vorteilhafte Weiterbildungen der Erfindung sind Gegenstand der abhängigen Ansprüche.

Eine derartige Kühlvorrichtung ist zur Kühlung eines optoelektronischen Halbleiterbauelements ausgebildet und weist zumindest in einem oder einer Mehrzahl von Teilbereichen eine erste Schicht und eine zweite Schicht und eine Einrichtung zur Wärmeableitung auf, bei der die erste Schicht und die zweite Schicht flächig aufeinander angeordnet sind und wenigstens in einem oder einer Mehrzahl von Teilbereichen eine der Schichten mit einer Struktur versehen ist, die zur Aufnahme der Einrichtung zur Wärmeableitung ausgebildet ist.

Die Verwendung doppelwandiger Schichtsysteme mit integrierten Ableitungskanälen ist dabei von besonderem Vorteil. Schichtsysteme können aus strukturierten und unstrukturierten Schichten zusammengesetzt sein. Sie können als Wärmeleiter (Heatpipe) oder als Thermosiphon oder in Verbindung mit einem integrierten porösen Feststoff als Thermal-Base oder als Kondensationsbereich verwendet werden. Gleichzeitig können die einzelnen Schichten alleine oder im Verbund noch weitere Funktionen ausfüllen, z.B. als Fahrzeugkarosserieteil, als Lampenschirm, als Standfuß, als Ständer, als Gerätegehäuse, als Reflektor, als optisches Bauelement oder auch als tragendes Teil.

Dieses funktionelle duale Konzept hat mehrere Vorteile: Die Verwendung zusätzlicher Teile kann reduziert oder verhindert werden, da die Kühlungseinrichtung in ein oder einer Mehrzahl von Teilen einer zu kühlenden, ein Halbleiterbauelement aufweisenden Halbleitervorrichtung, wie einem oder einer Mehrzahl von Reflektoren oder einem Gehäuse integriert werden kann, wobei die Teile bei der der Halbleitervorrichtung bevorzugt ohnehin vorgesehen sind. Zusätzliches Gewicht kann dadurch verringert oder vermieden werden. Die Einsatzmöglichkeiten von Kühleinrichtungen und optoelektronischen Halbleiterbauelementen vergrößern sich, da größerer Leistungsdurchsatz auf kleinerem Raum vereinfacht realisierbar wird.

Eine vorteilhafte Ausführungsform der Erfindung bietet die Integration eines Thermosiphons zur Kühlung. Bei einem Thermosiphon wird das Kondensat der Kühlflüssigkeit durch die Schwerkraft von einem Kondensationsbereich zurück zu einer Verdampfungseinheit befördert. Deshalb muss die Wärmequelle oder zumindest die Verdampfungseinheit unterhalb des Kondensationsbereichs liegen, damit im Betriebszustand der Flüssigkeitsspiegel bezüglich des Erdmittelpunkts oberhalb des zu kühlenden Objektes liegt. Bei unterschiedlichen erfindungsgemäßen Ausführungsformen können der Kondensationsbereich, die Verdampfungseinheit, die verbindenden Ableitungskanäle oder auch nur Teile dieser Einrichtungen in ein oder eine Mehrzahl der doppelwandigen Schichtsysteme integriert sein. In einem speziellen Fall kann auch der gesamte Thermosiphon in einem doppelwandigen Schichtsystem enthalten sein.

Eine weitere vorteilhafte Ausführungsform der Erfindung ist durch die Integration einer Heatpipe gekennzeichnet. In einem derartigen Wärmeleiter werden flüssige oder gasförmige Medien zum Wärmetransport verwendet. Die Effizienz der Wärmeleitung von Thermosiphons und Heatpipes liegt wegen der Phasenumwandlung mit einem Wärmeleitwert von 4000 bis 7000 W/m*K signifikant über dem der besten Festkörperwärmeleiter. Zum Vergleich: Der Wärmeleitwert von Diamant liegt bei lediglich 1000 bis 2000 W/m*K.

Eine weitere vorteilhafte Ausführungsform der Erfindung entsteht, wenn die Kühlvorrichtung eine Heatpipe enthält, die dazu dient, die Abwärme des optoelektronischen Halbleiterbauelementes effizient an einen Ort mit gutem Thermopotential abzuführen. Vorrichtungen, die bei Aufnahme von Wärmeenergie ihre Eigentemperatur nur langsam bzw. geringfügig ändern, sind gute Thermopotentiale.

Eine weitere vorteilhafte Ausführungsform der Erfindung entsteht, wenn die Kühlvorrichtung ein Thermosiphon enthält, der dazu dient, die Abwärme des optoelektronischen Halbleiterbauelementes effizient an einen Ort mit gutem Thermopotential abzuführen.

Eine weitere vorteilhafte Ausführungsform der Erfindung entsteht, wenn die Kühlvorrichtung eine Thermal-Base enthält. Eine Thermal-Base ist eine Kühleinrichtung, deren Funktionsweise analog der eines Thermosiphons ist. Die Thermal-Base enthält allerdings zusätzlich einen porösen Füllstoff, dessen Kapillarwirkung einen von der Schwerkraft unabhängigen Flüssigkeitstransport ermöglicht.

Eine weitere vorteilhafte Ausführungsform der Erfindung entsteht, wenn die Kühlvorrichtung einen Kondensationsbereich enthält. Im Kondensationsbereich kann verdampfte Kühlflüssigkeit kondensieren und somit ein Großteil der zuvor aufgenommenen Wärmeenergie an ein z.B. externes Wärmereservoir abgegeben werden.

Die Kühlvorrichtung ist teilweise oder vollständig in ein das optoelektronische Halbleiterbauelement enthaltende Gehäuse oder Gehäusebauteil integriert.

Teilbereiche der Schichten sind als Montageplatten ausgestaltet, da bei einer direkten Montage des optoelektronischen Halbleiterbauelements auf Schichten der Kühlvorrichtung eine effizientere Wärmeableitung gewährleistet ist. Zusätzlich können Teilbereiche der Schichten auch als Montageplatten für weitere Bestandteile der das optoelektronische Halbleiterbauelement enthaltenden Vorrichtung dienen.

Ein oder eine Mehrzahl von Ableitungskanälen der Kühlflüssigkeit sind einseitig oder doppelseitig in die Schichten integriert. Insbesondere bei einseitiger Integration kann eine Seite der ebenen, nicht mit Kanälen versehenen Schicht als Montagefläche, z.B. für das Halbleiterbauelement, vorgesehen werden. Bei doppelseitiger Integration lassen sich auf einfache Weise symmetrische und/oder größere Querschnitte, insbesondere eine größere Querschnittsfläche, des oder der Ableitungskanäle erreichen.

Eine weitere vorteilhafte Ausführungsform der Erfindung entsteht, wenn die Kühlvorrichtung einen Kondensationsbereich enthält und dieser Kondensationsbereich mindestens in einem oder einer Mehrzahl von Teilbereichen eines Querschnitts eine mäanderförmige Struktur aufweist. Unabhängig davon kann auch ein an den Kondensationsbereich angrenzender Teilbereich des Gehäuses eine solche Struktur aufweisen, um damit insbesondere als gutes Thermopotential zu fungieren.

Eine weitere vorteilhafte Ausführungsform der Erfindung entsteht, wenn das zu kühlende optoelektronische Halbleiterbauelement der Kühlvorrichtung ein LED-Array ist oder mehrere Optohalbleiterchips enthält. Das optoelektronische Halbleiterbauelement kann aber auch Halbleiterlaser oder einzelne konventionelle oder organische LEDs enthalten.

Ein oder eine Mehrzahl der Ableitungskanäle können durch eine oder eine Mehrzahl von tiefgezogenen Rillen in einer oder beiden Schichten realisiert sein. Die Herstellung von tiefgezogenen Rillen bietet, insbesondere in einer oder einer Mehrzahl von metallischen Schichten ein einfaches und kostengünstiges Herstellungsverfahren.

Eine weitere vorteilhafte Ausführungsform der Erfindung entsteht, wenn ein poröses Festkörpermaterial in einen oder eine Mehrzahl von Ableitungskanälen der Kühlvorrichtung eingebracht ist. Dadurch läßt sich der Aufbau einer Thermal-Base realisieren.

Eine andere vorteilhafte Ausführungsform der Erfindung entsteht, wenn als Kühlflüssigkeit in der Einrichtung ein Element oder eine Kombination von einem oder einer Mehrzahl von, insbesondere verschiedenen, Elementen der Gruppe bestehend aus Wasser, organisches Lösungsmittel, Ethanol, Triethylenglykol, fluorierter und/oder chlorierter Kohlenwasserstoff, insbesondere ein Fluorkohlenwasserstoff, ein Chlorkohlenwasserstoff oder ein Fluorchlorkohlenwasserstoff, z.B. Freon, verwendet wird.

Mehrere Rillen, die Ableitungskanäle bilden können, können in der Kühlvorrichtung enthalten sein. Diese Rillen können in beispielhafter Weise parallel oder in einem Fischgräten ähnlichen Muster angeordnet sein. Allerdings können weitere Ausführungsformen auch andere geeignete geometrische Muster aufweisen.

Bei einer vorteilhaften Ausführungsform der Erfindung enthält eine oder eine Mehrzahl der Schichten oder enthalten die Schichten ein Metall oder Metalle, eine Metalllegierung oder Metalllegierungen, einen Kunststoff oder Kunststoffe oder eine Keramik oder Keramiken. Gegebenenfalls können zwei Schichten verschiedene Materialien enthalten.

Eine weitere vorteilhafte Ausführungsform der Erfindung entsteht, wenn der Flüssigkeitsspiegel der Kühleinrichtung im Betriebszustand, vom Erdmittelpunkt aus gesehen, oberhalb der Anordnung des optoelektronischen Halbleiterbauelementes, insbesondere oberhalb des Halbleiterbauelements, liegt. Dadurch kann Kondensat gravitationsgetrieben zu dem zu kühlenden Halbleiterbauelement zurückströmen und somit wieder zur Wärmeableitung genutzt werden. Ein Thermosiphon ist damit realisiert.

Eines oder mehrere Teile der Kühlvorrichtung sind in ein Bestandteil der das optoelektronische Halbleiterbauelement enthaltenden Vorrichtung integriert. Aufgrund der vielfältigen Anwendungsmöglichkeiten von optoelektronischen Halbleiterbauelementen seien beispielhaft das Gehäuse eines Projektors, das Gehäuse einer Lampe, eines Scheinwerfers oder ein Kfz-Karosserieteil wie eines Kotflügels, einer Motorhaube, einer Türe oder eines Dachelementes genannt. Möglich ist auch die Integration der Kühlvorrichtung in ein optisches Element des Halbleiterbauelementes wie eines Reflektor, eines Filters, oder eines Leuchtmittels. Auch in ein tragendes Element einer Leuchtvorrichtung wie einen Ständer oder einen Standfuß kann eine erfindungsgemäße Vorrichtung integriert werden, Grundsätzlich kann die Kühlvorrichtung in alle ebenen und/oder gekrümmten Flächen der Bauteile von Optohalbleiter enthaltenden Vorrichtungen integriert werden.

Ein Reflektor weist bevorzugt zumindest eine gekrümmte Fläche auf, die zur Reflexion von im Halbleiterbauelement erzeugter Strahlung geeignet und/oder ausgebildet ist. Mittels des Reflektors kann im Halbleiterbauelement erzeugte Strahlung reflektiert und, insbesondere in eine vorgegebene Richtung, umgelenkt werden. Bevorzugt ist die Kühlvorrichtung zumindest zum Teil in eine ebene (Teil)Fläche des Reflektors oder einer den Reflektor umfassenden Vorrichtung integriert. Eine ebene Fläche ist zur Montage des Halbleiterbauelements und eine gekrümmte Fläche ist zur Strahlungsumlenkung besonders geeignet. Besonders bevorzugt ist die Kühlvorrichtung in den Reflektor eines Scheinwerfers integriert.

Die verwendete Kühlflüssigkeit kann einen Siedepunkt aufweisen, der im Bereich der Temperatur des Arbeitspunktes des optoelektronischen Halbleiterbauelementes liegt. Dadurch kann bei geeigneter Dimensionierung der Kühlvorrichtung, eine nahezu konstante Temperatur am Arbeitspunkt gehalten werden.

Eine oder mehrere der Schichten können durch Tiefziehen, Fräsen, Spritzgießen, Biegen, Formen, Stempeln, Ätzen, oder andere plastische Verformungsmethoden strukturiert werden. Die, insbesondere bereichsweise, Anwendung hoher Drücke auf verbundene Schichten kann Rillen bzw. Ableitungskanäle innerhalb der doppelwandigen Konstruktion erzeugen. Beispielhafterweise sei hierzu die Herstellung von Kanälen innerhalb doppelwandiger Konstruktionen mittels des Rollbond- oder Z-Bondverfahrens genannt.

Die Querschnitte, insbesondere die Querschnittsflächen, eines oder einer Mehrzahl von Kanälen können sowohl an die Art des Wärmetransportmediums und/oder dessen Menge, als auch an die gewünschte Wärmetransportleistung angepaßt sein.

Eine weitere vorteilhafte Ausführungsform der Erfindung entsteht, wenn eine oder mehrere Schichten der Kühlvorrichtung ganz oder teilweise mit weiteren Materialien beschichtet sind. Da die Kühlvorrichtung teilweise oder ganz in verschiedene Bestandteile einer Leuchtvorrichtung integriert sein kann, ist in vielen Fällen eine zusätzliche Beschichtung vorteilhaft. Beispielsweise kann die Kühlvorrichtung in einen Reflektor integriert und die Oberfläche des Reflektors mit einer zusätzlichen Reflexionsschicht versehen sein, die ein geeigneteres Reflexionsvermögen besitzt und bevorzugt reflexionssteigernd wirkt. Bei Leuchtvorrichtungen, die eine integrierte Kühleinrichtung in einer Außenfläche aufweisen, kann aus ästhetischen Gründen vorteilhaft eine Bemalungs- oder Lackschicht angebracht sein.

Entsprechend der Funktion eines Bestandteils der Kühlvorrichtung können Klebebeschichtungen, Leuchtmittelbeschichtungen, reflexive schmutzabweisende, selbstreinigende, elektrisch- und/oder thermisch leitfähige Beschichtungen vorteilhaft sein.

Die Schichten der Kühlvorrichtung können zumindest in einem oder einer Mehrzahl von Teilbereichen verbunden sein. In diesen Teilbereichen kann dann eine Einrichtung zur Kühlung des Bauelements integriert sein. Nicht verbundene Teilbereiche der Schichten hingegen können konstruktionsbedingt ebenfalls vorteilhaft sein. Deshalb müssen die Schichten auch nicht in allen Bereichen flächig aufeinander angeordnet sein. Eine Ausbildung eines oder einer Mehrzahl von im wesentlichen dichten Ableitungskanälen soll jedoch hierdurch bevorzugt nicht erschwert werden. Als Techniken zur Verbindung kommen alle gängigen Verbindungstechniken in Frage, beispielhaft seien Klebe-, Schweiß-, Schnapp-, Rast-, Löt- oder Heißverstemm-Verbindungen genannt. Eine Schweissverbindung kann als Diffusionsschweissverbindung ausgeführt sein.

Eine weitere vorteilhafte Ausführungsform der Erfindung entsteht, wenn die verbundenen Schichten die Kühlflüssigkeiten und deren Gas zumindest in einem oder einer Mehrzahl von Teilbereichen dicht umschließen. Dadurch kann der Kühlprozess vereinfacht als Kreislauf gestaltet werden.

Eine erfindungsgemäße Kühlvorrichtung kann zumindest teilweise in eine Informationswiedergabevorrichtung integriert sein. Besonders vorteilhaft ist dies, wenn die Informationswiedergabevorrichtung eine Anzeigevorrichtung, etwa eine Einrichtung zur Bildwiedergabe, aufweist, weil dort im Falle einer Beleuchtung, große Abwärmemengen anfallen können.

Auch ein Projektionsgerät, insbesondere ein Rückprojektions(fernseh)gerät, kann vorteilhafterweise mit einer oder einer Mehrzahl von erfindungsgemäßen Kühlvorrichtungen ausgestattet sein. Dort eignen sich insbesondere Rahmen, Montageplattformen, Umlenkspiegel und Spiegelhalterungen, um darin eine erfindungsgemäße Kühlvorrichtung zumindest teilweise zu integrieren.

Im Folgenden wird die Erfindung anhand von bevorzugten Ausführungsformen unter Bezug auf die Figuren 1 bis 6 näher erläutert. Die Figuren sind nur schematische oder perspektivische und nicht maßstabsgetreue Darstellungen.

Es zeigen:
Figur 1 das Konstruktionsprinzip der Kühlvorrichtung mit zwei strukturierten Schichten,
Figur 2 das Konstruktionsprinzip der Kühlvorrichtung mit einer strukturierten und einer unstrukturierten Schicht,
Figur 3 ein Beispiel einer Gehäuseform mit integrierter Kühlvorrichtung,
Figur 4 ein Beispiel einer Gehäuseform mit integrierter Kühlvorrichtung,
Figur 5 eine perspektivische (5a) und eine Querschnittsdarstellung (5b) einer Leuchtanordnung mit integrierter Kühlvorrichtung im Reflektor und
Figur 6 eine Querschnittsdarstellung einer Leuchtanordnung mit integrierter Kühlvorrichtung im Reflektor.

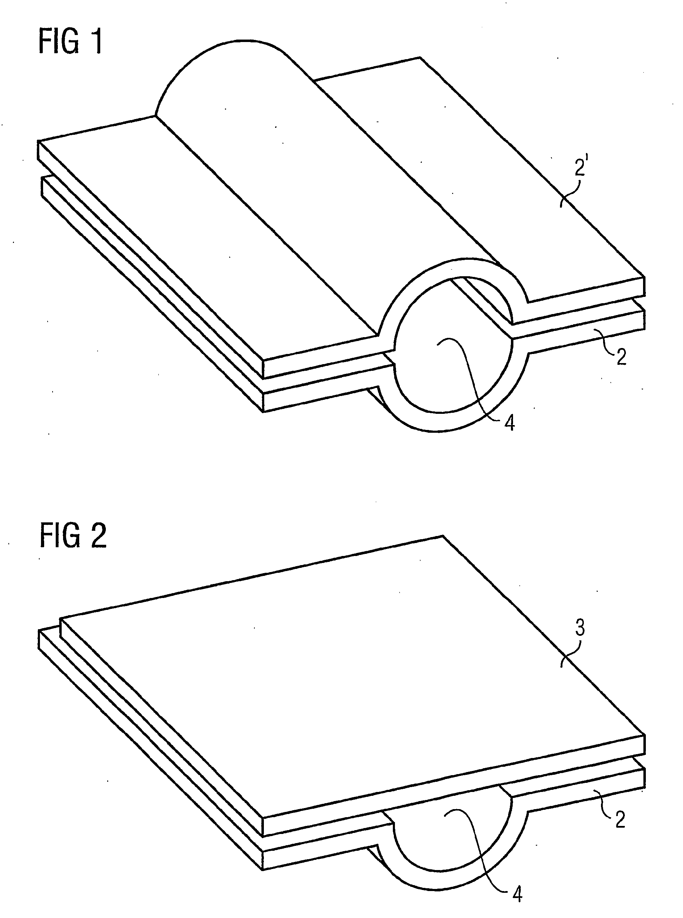

Figur 1 zeigt eine vereinfacht dargestellte vorteilhafte Ausführungsform der Kühlvorrichtung mit integriertem Ableitungskanal. Dabei werden zwei strukturierte Schichten 2 und 2' mit eingebrachten Rillen jeweils so zueinander montiert, dass die beiden Rillen mit ihrer offenen Seite passend zueinander liegen und somit einen Ableitungskanal bilden, der zur Aufnahme einer Einrichtung zur Wärmeableitung 4 geeignet ist. Bei diesem vorteilhaften Ausführungsbeispiel ist der Querschnitt der Rillen halbkreisförmig gestaltet.

Weitere Ausführungen sind aber auch mit anderen Querschnittsgeometrien möglich, beispielhaft seien hier dreiecksförmige oder rechteckige Formen genannt. Aufgrund der vereinfachten Darstellung des Prinzips ist in Figur 1 nur ein einziger Ableitungskanal eingezeichnet.

Vorteilhafte Ausführungen können aber mehrere solche Ableitungskanäle enthalten. Diese Ableitungskanäle können, je nach Anwendung in verschiedenen geometrischen Mustern eingebracht sein. Denkbar sind Fischgrätmuster, parallele, periodische Anordnungen der Kanäle, aber auch unregelmäßige Anordnungen die z.B. die Stabilität der Vorrichtung unterstützen.

Beim Einbringen der Rillen oder Vertiefungen ist darauf zu achten, dass diese spiegelsymmetrisch zueinander passend ausgestaltet sind, so dass bei der Montage der einzelnen Schichten 2 und 2' die Vertiefungen passend zueinander liegen und Ableitungskanäle ausbilden. In einer speziellen Ausführungsform kann die Anordnung der Struktur so gewählt werden, das beide Schichten 2 und 2' mit nur einem formgebenden Werkzeug realisiert werden. Bei der Montage werden die beiden Schichten 2 miteinander so verbunden, dass die entstehenden Ableitungskanäle dicht abgeschlossen sind und eine doppelwandige Konstruktion entsteht. Die verbundenen Schichten bilden dabei die Wände der Konstruktion.
Um eine Verbindung herzustellen kommen alle üblichen Verbindungstechniken in Frage, beispielshalber seien folgende Verbindungstechniken genannt: Klebe-, Schweiß-, Schnapp-, Rast-, Löt- oder heißverstemmte Verbindungen.

In einer hier nicht dargestellten Ausführungsform kann zur Abdichtung der Ableitungskanäle oder zur Verbindung der Schichten auch eine zusätzliche Schicht zwischen den Schichten 2 und 2' beziehungsweise 2 und 3 eingebracht werden, die an den Orten der Vertiefungen zumindest in Teilbereichen unterbrochen ausgeführt ist. Eine solche zusätzliche Schicht kann aus einem oder einer Mehrzahl von plastischen und/oder elastischen Materialien bestehen, um eine Abdichtung der Ableitungskanäle zu ermöglichen. Des weiteren kann eine zusätzliche Schicht auch eine Verbindung zwischen den beiden äußeren Schichten herstellen oder fördern, beispielsweise kann die Schicht beidseitig klebend sein.

Figur 2 zeigt eine weitere vereinfacht dargestellte Ausführungsform des erfindungsgemäßen Konstruktionsprinzips, bei der die Vertiefungen der Ableitungskanäle nur einseitig in eine Schicht eingebracht sind. Damit kann die ebene Schicht 3 z.B. als Montagefläche verwendet werden. Weitere Ausführungsformen können auch Mischformen der in Figur 1 und 2 dargestellten Konstruktionsprinzipien sein. Beispielshaft können Ableitungskanäle gemäß der Figuren 1 und 2 ineinander übergehen oder nebeneinander angeordnet sein.
In Figur 2 wurde analog zu Figur 1 nur ein einzelner Ableitungskanal dargestellt. Bezüglich weiterer Ausführungsformen mit mehreren Kanälen nach dem Prinzip der Figur 2 sind auch hier die in der Beschreibung von Figur 1 genannten Anordnungen realisierbar. Die entstehenden Ableitungskanäle können Einrichtungen zur Wärmeableitung aufnehmen, welche sowohl als offene als auch als geschlossenen Kühlsysteme ausgebildet sein können.

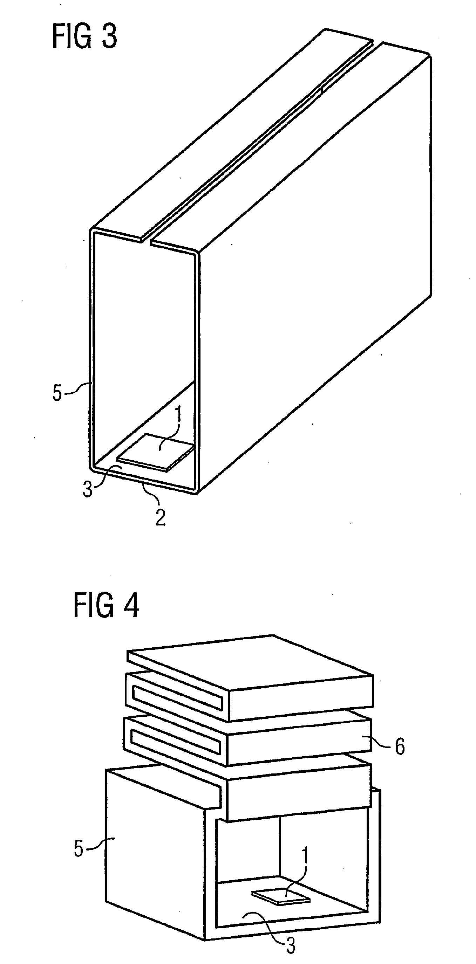

Figur 3 zeigt weitere vorteilhafte Ausführungsformen der Erfindung. Dabei wird ein Opto-Halbleiter 1, auf einer Schicht 3, die zumindest unterhalb des Halbleiters 1 dem Konstruktionsprinzip der Figur 2 entspricht, montiert. Das restliche Gehäuse kann dann entsprechend der Konstruktionsprinzipien der Figuren 1 oder 2 aufgebaut sein. Die Ableitungskanäle unterhalb des Halbleiters kommunizieren mit Kanälen im restlichen Gehäuse. Diese Kommunikation kann in Form eines Thermosiphons oder in Form einer Thermal-Base gestaltet sein. Schichten 2 oder 3 bilden zusammen mit ihren entsprechenden Gegenstücken die doppelwandige Gehäusestruktur 5.

Figur 4 zeigt eine zumindest in Teilbereichen doppelwandig ausgeführte Gehäusestruktur analog zur Figur 3, wobei ein Gehäuseteil 6 mäanderförmig ausgeführt ist. Diese Ausführungsform beinhaltet eine größere Oberfläche und damit eine Steigerung der Wärmeableitung in diesem Bereich.

Das mäanderförmige Gehäuseteil 6 kann einfach- oder doppelwandig, mit oder ohne integrierte Kühleinrichtung ausgeführt sein.

Gehäuse, wie sie in den Figuren 3 und 4 dargestellt sind, eignen sich z.B. als Bauformen für LED-Projektoren. Die Kühleinrichtung des Opto-Halbleiters 1 ist in beiden Fällen funktionell in die Gehäusestruktur integriert.

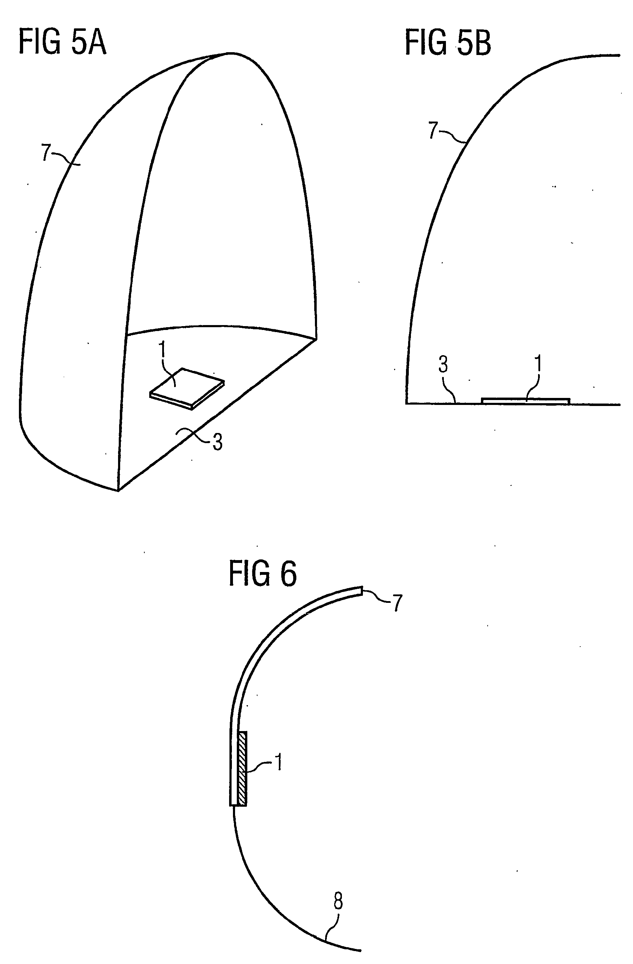

Figur 5a) zeigt die funktionelle Ausgestaltung eines Kondensationsbereichs als Reflektor 7. Die Ableitungskanäle verlaufen innerhalb der erfindungsgemäß doppelwandigen bzw. doppelschichtigen Konstruktion des Reflektors 7. Die Innenseite des Reflektors kann zusätzlich noch mit einem reflexionsverstärkenden Material beschichtet sein oder nur die Reflexionsfähigkeit eines blanken Metalls wie z.B. Aluminium nutzen.

Die Ausführung des Montagebereiches unterhalb des Opto-Halbleiters 1 entspricht dem Konstruktionsprinzip von Figur 2. Der restliche Bereich kann analog des Konstruktionsprinzips von Figur 1 und/oder von Figur 2 ausgeführt sein.

Figur 5b) zeigt einen Querschnitt der Ausführungsform von Figur 5a) in einer Schnittebene durch das Halbleiterbauelement 1. Dabei zeigt sich, dass die Reflektorstruktur vorteilhaft sowohl als Thermosiphon mit gravitationsbetriebener Kondensat-Rückführung als auch als Thermal-Base mit einem porösen Füllmaterial und Kapillarkraft getriebener Kondensatrückführung, insbesondere entgegen der Gravitationskraft, ausgestaltet sein kann. Die Außenseite des Reflektors kann zusätzlich Kühlrippen enthalten.

Figur 6) zeigt einen Querschnitt durch eine weitere erfindungsgemäße Ausführungsform eines Reflektors als Thermosiphon. Ein Teil des Reflektors 7 ist im oberen Bereich gemäß der Prinzipien der Figuren 1 und 2 ausgeführt, die Ableitungskanäle stellen gemeinsam mit der enthaltenen Flüssigkeit einen Thermosiphon dar.

Der Opto-Halbleiter 1 ist auf einem Bereich des Reflektors 7 aufgebracht, der dem Prinzip gemäß Figur 2 entspricht. Der untere Teil 8 des Reflektors ist nach konventioneller Technik, ohne zusätzliche Funktion hergestellt, da der Wärmeaufnahme- und Verdampfungsbereich des Thermosiphons bezüglich der Gravitation damit bereits unterhalb der Wärmequelle liegt. Der untere Teil 8 des Reflektors wird dabei nicht als Kühleinrichtung benutzt und bedarf daher keiner doppelwandigen Ausgestaltung.

## Patentansprüche

1. Vorrichtung, die ein optoelektronisches Halbleiterbauelement enthält und in die eine Kühlvorrichtung zur Kühlung des Halbleiterbauelementes (1) integriert ist, wobei - die Kühlvorrichtung zumindest in Teilbereichen eine erste Schicht und eine zweite Schicht und eine Einrichtung zur Wärmeableitung (4) aufweist, bei der die erste Schicht und die zweite Schicht flächig aufeinander angeordnet sind und wenigstens in Teilbereichen eine der Schichten mit einer Struktur versehen ist, die zur Aufnahme der Einrichtung zur Wärmeableitung (4) ausgebildet ist;
- die Einrichtung zur Wärmeableitung (4) aus mindestens einem Ableitungskanal gebildet ist, der ein Kühlmedium enthält;
- der Ableitungskanal mittels einer Rille in wenigstens einer der beiden Schichten geformt ist;
- eine der Schichten zumindest in Teilbereichen als Montageplatte ausgebildet ist, auf die das optoelektronische Halbleiterbauelement montiert ist;
- mindestens ein Teil der Kühlvorrichtung in ein Gehäuseteil eines Scheinwerfers oder einer Lampe integriert ist; und
- zumindest Teile der Kühlvorrichtung als Reflektor für das optoelektronische Halbleiterbauelement ausgebildet sind.

2. Vorrichtung nach Anspruch 1,
**dadurch gekennzeichnet, dass**
die Kühlvorrichtung mindestens ein Element aus der Gruppe Thermosiphon, Heatpipe, Thermal-Base und Kondensationsbereich enthält.

3. Vorrichtung nach einem der vorangegangenen Ansprüche,
**dadurch gekennzeichnet, dass** die Kühlvorrichtung einen mäanderförmige Kühlrippenbereich aufweist.

4. Vorrichtung nach einem der vorangegangenen Ansprüche,
**dadurch gekennzeichnet, dass** die Kühlvorrichtung einen zusätzlichen Wärmetauscher aufweist.

5. Vorrichtung nach einem der vorangegangenen Ansprüche,
**dadurch gekennzeichnet, dass**
das zu kühlende Halbleiterbauelement (1) ein LED-Array oder mindestens einen Opto-Halbleiterchip enthält.

6. Vorrichtung nach einem der vorangegangenen Ansprüche,
**dadurch gekennzeichnet, dass**
der Ableitungskanal zumindest teilweise mit einem porösen Festkörper bestückt ist.

7. Vorrichtung nach einem der vorangegangenen Ansprüche,
**dadurch gekennzeichnet, dass**
die Einrichtung zur Wärmeableitung (4) als Medium zum Wärmetransport ein Element oder eine Mischung von Elementen der Gruppe bestehend aus Wasser, organisches Lösungsmittel, Ethanol, Triethylenglykol, fluorierte und chlorierte Fluorkohlenwasserstoffe enthält.

8. Vorrichtung nach einem oder mehreren der vorangegangenen Ansprüche,
**dadurch gekennzeichnet, dass**
die Schichten ein Material der Gruppe gebildet aus Metall, Metallegierungen, Kunststoffen und Keramiken enthalten.

9. Vorrichtung nach mindestens einem der vorangegangenen Ansprüche,
bei der mindestens eine der Schichten zumindest teilweise mit einer weiteren Schicht überzogen ist.

10. Vorrichtung nach mindestens einem der vorangegangenen Ansprüche,
bei der die erste und die zweite Schicht zumindest teilweise mit einer oder mehrerer Verbindungstechniken der Gruppe bestehend aus Verklebung, Verschweissung, Verschnappung, verrastung, Verlötung und Heißverstemmung verbunden sind.

11. Vorrichtung nach mindestens einem der vorangegangenen Ansprüche,
bei der die beiden Schichten zumindestens in Teilbereichen eine Flüssigkeit oder ein Gas dicht umschließen.

## Claims

1. A device which contains an optoelectronic semiconductor component and into which is integrated a cooling device for cooling the semiconductor component (1) wherein
- the cooling device has at least in partial regions a first layer and a second layer and a unit for heat dissipation (4), in which the first layer and the second layer are arranged areally on one another and, at least in partial regions one of the layers is provided with a structure designed for receiving the unit for heat dissipation (4);
- the unit for heat dissipation (4) is formed from at least one dissipation channel containing a cooling medium;
- the dissipation channel is shaped by means of a groove in at least one of the two layers;
- one of the layers is embodied at least in partial regions as a mounting plate, onto which the optoelectronic semiconductor component is mounted;
- at least one part of the cooling device is integrated into a housing part of a headlight or of a lamp; and
- at least parts of the cooling device are embodied as reflector for the optoelectronic semiconductor component.

2. The device according to Claim 1,
**characterized in that**
the cooling device contains at least one element from the group thermosiphon, heat pipe, thermal base and condensation region.

3. The device according to either of the preceding claims,
**characterized in that** the cooling device has a meandering cooling rib region.

4. The device according to any of the preceding claims, **characterized in that** the cooling device has an additional heat exchanger.

5. The device according to any of the preceding claims, **characterized in that**
the semiconductor component (1) to be cooled contains an LED array or at least one opto-semiconductor chip.

6. The device according to any of the preceding claims, **characterized in that**
the dissipation channel is equipped at least partly with a porous solid.

7. The device according to any of the preceding claims, **characterized in that**
the unit for heat dissipation (4) contains as medium for heat transport an element or a mixture of elements from the group consisting of water, organic solvent, ethanol, triethylene glycol, fluorinated and chlorinated fluorocarbons.

8. The device according to one or more of the preceding claims,
**characterized in that**
the layers contain a material from the group formed from metal, metal alloys, plastics and ceramics.

9. The device according to at least one of the preceding claims,
wherein at least one of the layers is coated at least partly with a further layer.

10. The device according to at least one of the preceding claims,
wherein the first and the second layer are connected at least partly by means of one or more connection techniques from the group consisting of adhesive bonding, welding, snap-action connection, latching, soldering and hot caulking.

11. The device according to at least one of the preceding claims,
wherein the two layers tightly enclose a liquid or a gas at least in partial regions.

## Revendications

1. Dispositif contenant un composant opto-électronique semi-conducteur et intégré dans un dispositif de refroidissement destiné à refroidir le composant semi-conducteur (1),
le dispositif de refroidissement présentant au moins dans certaines parties une première couche et une deuxième couche ainsi qu'un dispositif (4) d'évacuation de chaleur,
la première couche et la deuxième couche étant disposées à plat l'une au-dessus de l'autre et au moins certaines parties de l'une des couches étant dotées d'une structure configurée pour reprendre le dispositif (4) d'évacuation de chaleur,
le dispositif (4) d'évacuation de chaleur étant formé d'au moins un canal d'évacuation qui contient un fluide de refroidissement,
le canal d'évacuation étant formé d'au moins une rainure ménagée dans au moins l'une des deux couches,
au moins certaines parties d'une des deux couches étant configurées comme plaque de montage sur laquelle le composant opto-électronique semi-conducteur est monté,
au moins une partie du dispositif de refroidissement étant intégrée dans une partie de boîtier de phare ou de lampe et
au moins certaines parties du dispositif de refroidissement étant configurées comme réflecteurs pour éléments opto-électroniques semi-conducteurs.

2. Dispositif selon la revendication 1, **caractérisé en ce que** le dispositif de refroidissement contient au moins un élément de l'ensemble constitué des thermosiphons, des conduits de chaleur, des bases thermiques et des zones de condensation.

3. Dispositif selon l'une des revendications précédentes, **caractérisé en ce que** le dispositif de refroidissement présente une partie formant des nervures de refroidissement en méandres.

4. Dispositif selon l'une des revendications précédentes, **caractérisé en ce que** le dispositif de refroidissement présente de plus un échangeur de chaleur.

5. Dispositif selon l'une des revendications précédentes, **caractérisé en ce que** le composant semi-conducteur (1) à refroidir contient une batterie de LED ou au moins une puce optique semi-conductrice.

6. Dispositif selon l'une des revendications précédentes, **caractérisé en ce qu'**au moins une partie du canal d'évacuation est dotée d'un corps solide poreux.

7. Dispositif selon l'une des revendications précédentes, **caractérisé en ce que** le dispositif (4) d'évacuation de chaleur contient comme fluide de transport calorifique un élément ou un mélange des éléments de l'ensemble constitué de l'eau, des solvants organiques, de l'éthanol, du triéthylène glycol et des hydrocarbures fluorés ou chlorés.

8. Dispositif selon l'une des revendications précédentes, **caractérisé en ce que** les couches contiennent un matériau de l'ensemble formé des métaux, des alliages de métaux, des matières synthétiques et des céramiques.

9. Dispositif selon l'une des revendications précédentes, dans lequel au moins une partie d'au moins l'une des couches est recouverte par une autre couche.

10. Dispositif selon l'une des revendications précédentes, dans lequel au moins des parties de la première et de la deuxième couche sont reliées en recourant à une ou plusieurs des techniques de liaison de l'ensemble constitué du collage, du soudage, de l'accrochage élastique, de l'encliquetage, du brasage et du matage thermique.

11. Dispositif selon l'une des revendications précédentes, dans lequel au moins certaines parties des deux couches enferment hermétiquement un liquide ou un gaz.
